**Europäisches Patentamt**

**European Patent Office**

**Office européen des brevets**

(19)

(11) Veröffentlichungsnummer: **0 341 647 B1**

(12)

# EUROPÄISCHE PATENTSCHRIFT

(45) Veröffentlichungstag der Patentschrift: **16.12.92**

(21) Anmeldenummer: **89108282.8**

(22) Anmeldetag: **09.05.89**

(51) Int. Cl.5: **H01L 29/78**, H01L 27/10, G11C 17/00

(54) **Nichtflüchtige Speicherzelle und Verfahren zur Herstellung.**

(30) Priorität: **13.05.88 DE 3816358**

(43) Veröffentlichungstag der Anmeldung:
**15.11.89 Patentblatt  89/46**

(45) Bekanntmachung des Hinweises auf die
Patenterteilung:
**16.12.92 Patentblatt  92/51**

(84) Benannte Vertragsstaaten:
**DE FR GB IT NL**

(56) Entgegenhaltungen:
**EP-A- 0 177 986**
**US-A- 4 713 677**
**US-A- 4 796 228**

(73) Patentinhaber: **EUROSIL electronic GmbH**
**Erfurter Strasse 16**
**W-8057 Eching(DE)**

(72) Erfinder: **Otto, Joachim, Dipl.-Ing.**
**St. Benedikt Strasse 17**
**W-8044 Unterschleissheim(DE)**

(74) Vertreter: **Maute, Hans-Jürgen, Dipl.-Ing.**
**TELEFUNKEN electronic GmbH Theresien-**
**strasse 2**
**W-7100 Heilbronn(DE)**

EP 0 341 647 B1

**Beschreibung**

Die Erfindung betrifft eine nichtflüchtige Speicherzelle bildender FET mit einer Source- und Drainzone sowie einer Floating-Gate-Elektrode als Speicherelektrode zwischen der und dem Halbleiterkörper ein durchtunnelbares Dielektrikum angeordnet ist sowie die Verwendung einer solchen Speicherzelle. Weiterhin betrifft die Erfindung ein Verfahren zur Herstellung einer derartigen Speicherzelle.

Eine solche nichtflüchtige Speicherzelle ist aus der Literaturstelle "Nichtflüchtige Speicher: EEPROM's und NVRAM's" elektronik industrie 5 (1983), Seiten 13 bis 18, insbesondere auf Seite 13, Bild 1, wo ein von Intel für EEPROM's (electrical erasable programmable read only memory) entwickelter FLOTOX-Speichertransistor

(Floating-Gate-Tunnel-Oxid)

dargestellt und beschrieben ist. Eine EEPROM-Zelle, die die Grabentechnologie verwendet, ist aus US-A-4 713 677 bekannt.

Eine solche FLOTOX-Zelle ist elektrisch löschbar und stellt eine Weiterentwicklung der UV-löschbaren dar. Während dort beim Programmieren die Avalanche-Injektion dominiert und das Löschen, also das Entladen des Gates, durch Anregen der Elektronen mit UV-Strahlung erfolgt, nutzt man bei den EEPROM-Zellen zum Programmieren und zum Löschen den Tunnelmechanismus der Elektronen nach Fowler-Nordheim in vertikaler Richtung aus.

Beim FLOTOX-Speichertransistor von Intel gemäß der oben genannten Literaturstelle liegt das Tunneloxid über der Drainzone. Je nach den anliegenden Potentialen an den Elektroden entsteht im Tunneloxid ein elektrisches Feld, das entweder den Übertritt von Elektronen aus der Drainzone auf das Floating-Gate auslöst - das den Zustand der "logischen 1" repräsentiert - oder aber das das Floating-Gate entlädt, indem die Elektronen wieder zurück zur Drainzone tunneln, womit die "logische 0" programmiert ist. Zu jeder Speicherzelle gehört ein zum FLOTOX-Transistor in Serie liegender NMOS-Transistor zur Auswahl der Speicherzellen.

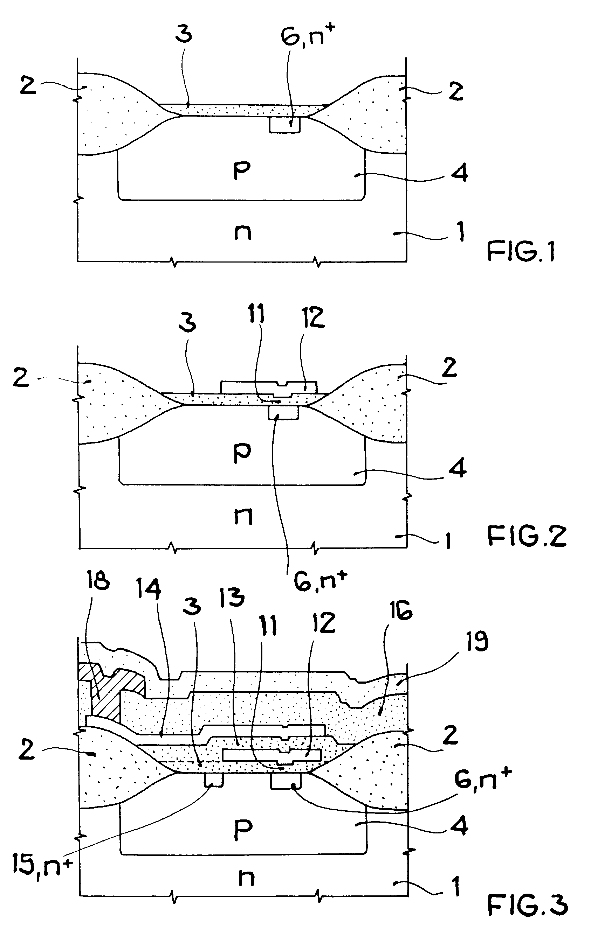

Im folgenden soll die Herstellung einer solchen bekannten FLOTOX-Speicherzelle anhand der Figuren 1 bis 3 beschrieben werden.

Gemäß Figur 1 wird auf einem n-dotierten Halbleitersubstrat 1 nach der Herstellung der aktiven Gebiete und einer p-Wanne 4 ein Gate-Oxid 3 und eine erste Fotolackschicht aufgebracht. Durch eine Öffnung des Fotolacks wird zur Herstellung der Drainzone mittels Ionenimplantation im Halbleitersubstrat 1 ein $n^+$-dotierter Bereich 6 geschaffen.

Ein Zweiter Fotolackschritt mit anschließendem Ätzen des Gate-Oxids 3 definiert über dem $n^+$-dotierten Bereich 6 gemäß Figur 2 das Tunnelfenster. Es folgen die Herstellung der Tunneloxidschicht 11 mit einer Dicke von ca. 100 Å und die Abscheidung der ersten Polysilizium-Ebene, die mit einem weiteren Fotolithografie- und Ätzschritt zur Herstellung der Floating-Gate-Elektrode 12 bearbeitet wird. Der weitere Prozeßablauf beginnt gemäß der Figur 3 mit der Herstellung der Interpoly-Isolationsschicht 13 und wird mit der Schaffung der $n^+$-dotierten Sourcezone 15 mittels Ionenimplantation fortgeführt.

Danach wird zur Herstellung der Gate-Elektrode 14 eine zweite Polysilizium-Ebene aufgetragen und anschließend die Oberfläche ganzflächig mit einer Isolationsschicht 16 abgedeckt. Schließlich werden in einem letzten Fotolithografie- und Ätzschritt die Kontaktlochbereiche 17 erzeugt und die Aluminiumleitbahnen 18 aufgedampft. Abschließend wird die gesamte Oberfläche mit einer Passivierungsschicht 19 abgedeckt.

Nachteile dieser konventionellen Technik liegen in der Definition des Tunnelfensters durch Fotolithografie-Schritte. Das Design der Speicherzellen muß so ausgelegt sein, daß das Tunnelfenster über dem $n^+$-Gebiet 6 liegt und seine Kanten nicht an die Kanten des Aktiv-Gebietes heranreichen. Dies stellt hohe Anforderungen an die Justiergenauigkeit und begrenzt gleichzeitig durch Maskenvorhalte die Minimierung des Designs. Zudem kann die Größe des Tunnelfensters mit vertretbarem Aufwand nur auf 2 µm x 2 µm reduziert werden.

Der Erfindung liegt daher die Aufgabe zugrunde, eine Speicherzelle der eingangs erwähnten Art zu schaffen, die ein Tunnelfenster aufweist, dessen Größe kleiner als 2 µm x 2 µm ist. Es ist eine weitere Aufgabe der vorliegenden Erfindung, ein Verfahren für die Herstellung solcher Speicherzellen anzugeben.

Ein alternatives Beispiel für eine Speicherzelle mit verkleinertem Tunnelfenster ist aus EP-A-0 177 986 bekannt.

Diese Aufgabe wird dadurch gelöst, daß im Halbleiterkörper ein an die der Kanalzone abgewandten Seite der Drainzone angrenzenden und mit einer Dielektrikumsschicht belegter Graben vorgesehen ist, und daß sich die Floating-Gate-Elektrode derart in den Graben erstreckt, daß der Tunnelstrom horizontal zur Halbleiteroberfläche zwischen Drainzone und dem sich in den Graben erstreckenden Bereich der Floating-Gate-Elektrode fließen kann.

Ein Vorteil dieser erfindungsgemäßen Struktur besteht in der Verkleinerung des Tunnelfensters, wodurch sich der Ankoppelfaktor verbessert, da die Fläche des Tunnelfensters und des Kanalgebietes einen großen Einfluß auf diesen Faktor haben. Die Größe des Tunnelfensters wird nur noch durch die Endtiefe des Grabens und der Größe der Floating-Gate-Elektrode auf der Seitenwand des Grabens bestimmt. Ferner erlaubt ein entsprechendes Design in einem Graben zwei oder mehrere solcher erfindungsgemäßer Speicherzellen anzuordnen, die gemäß einer bevorzugten Ausführungsform der Erfindung den Graben radial umgeben.

Gemäß einer ersten vorteilhaften Ausbildung der Erfindung ist der Graben quaderförmig ausgebildet und die Floating-Gate-Elektrode der Speicherzelle belegt eine Seitenwand des Grabens. Als besonders vorteilhaft hat sich ein Graben mit einer Tiefe von ca. 1,5 $\mu$m erwiesen.

In einer weiteren bevorzugten Weiterbildung der Erfindung werden die Floating-Gate-Elektroden zweier an einem quaderförmigen Graben angeordneten Speicherzellen so ausgebildet, daß sie zwei gegenüberliegende Seitenwände des Grabens belegen.

Das Verfahren der Erfindung zur Herstellung der Speicherzelle umfaßt die kennzeichnenden Merkmale des Anspruches 7. Vorteilhafte Weiterbildungen des erfindungsgemäßen Verfahrens sind den Ansprüchen 8 bis 22 zu entnehmen. Bei diesem Verfahren erfolgt die Herstellung des Tunnelfensters selbstjustierend, wobei die Justiergenauigkeit weniger kritisch als bei der Herstellung einer herkömmlichen Speicherzelle ist.

In vorteilhafter Weise weist eine solche erfindungsgemäß hergestellte Speicherzelle eine geringe Zellgröße auf, die zu einer höheren Integrationsdichte, beispielsweise in Speicherbausteinen, führt.

Die Erfindung soll im folgenden anhand der Zeichnungen näher erläutert werden.

Es zeigen:

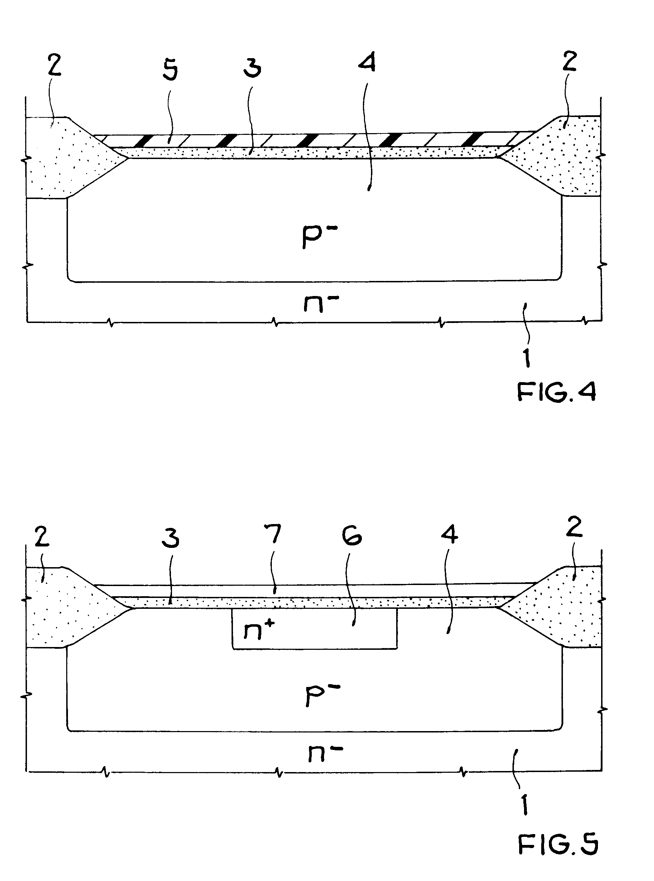

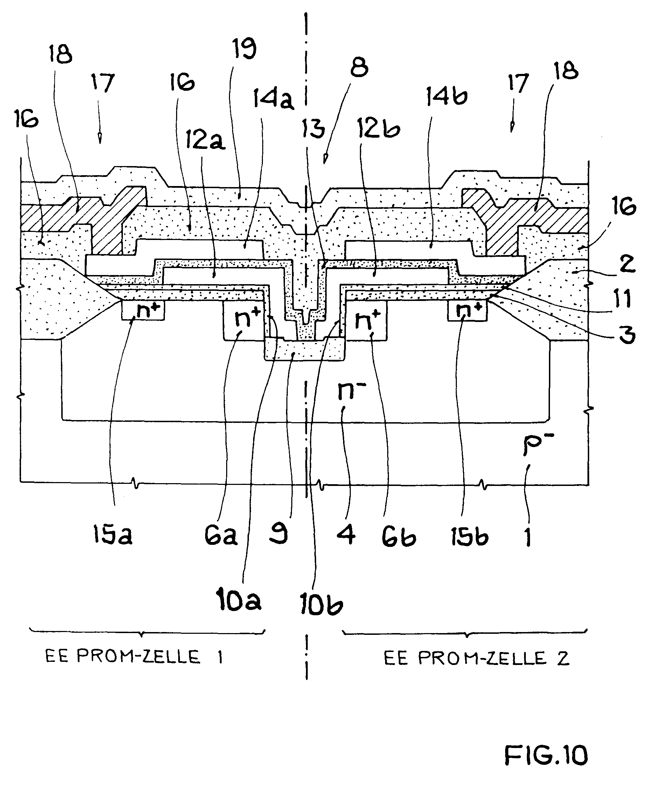

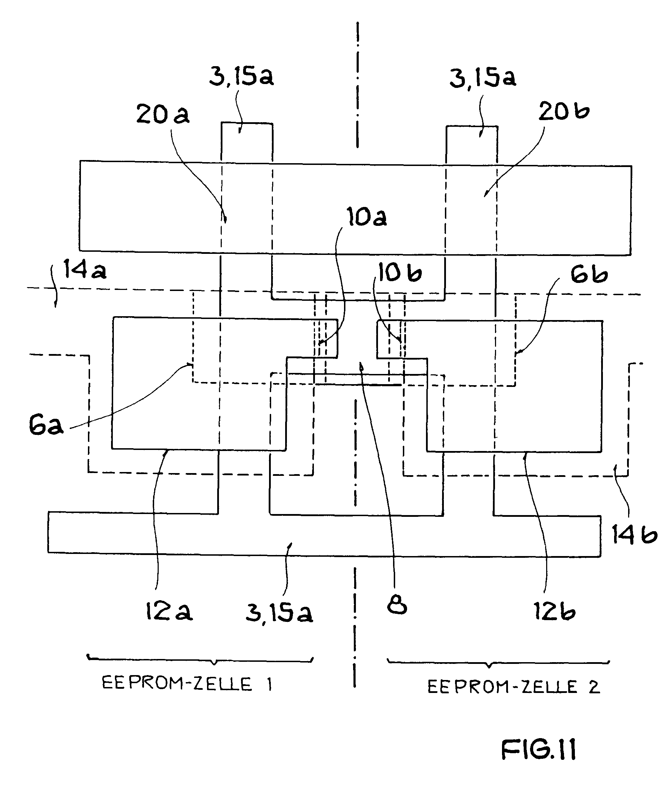

Die Figuren 4 bis 10 im Schnittbild aufeinanderfolgende Verfahrensschritte bis zu einer fertigen Speicherzelle, die Figur 11 das Layout zweier EEPROM-Speicherzellen gemäß Figur 10.

In den Figuren sind jeweils gleiche Elemente mit gleichen Bezugszeichen versehen.

Die Größen- und Dickenangaben in der nachfolgenden Beschreibung der Verfahrensschritte bis zur fertigen Speicherzelle beziehen sich auf eine 3-$\mu$m-Technologie.

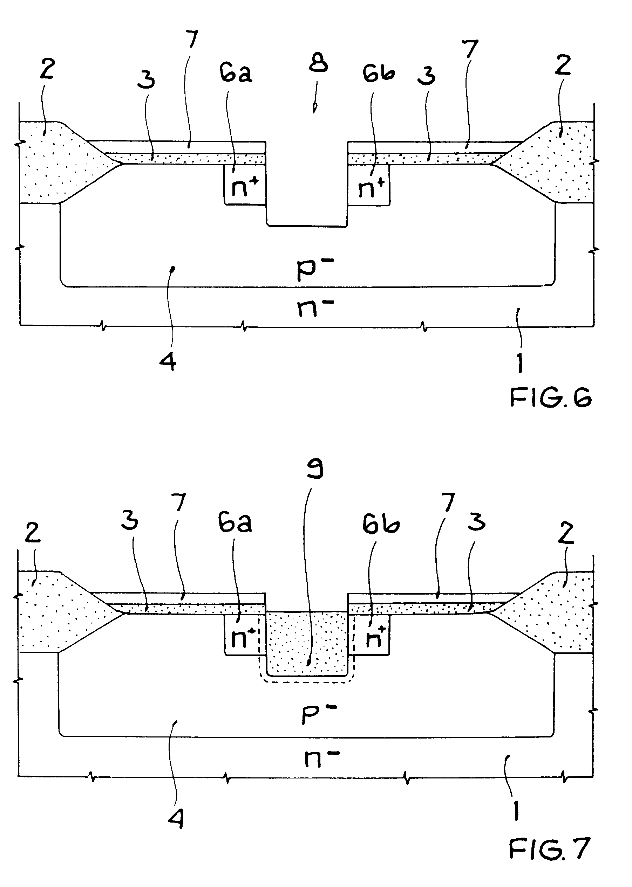

Die Figur 4 zeigt ein einkristallines, n$^-$-dotiertes Siliziumhalbleitersubstrat 1 nach erfolgter Herstellung der aktiven Fläche mittels lokaler Oxidation, der p$^-$-Wanne (4) sowie der Gate-Oxidschicht (3) mit einer Dicke von ca. 40 nm. Die Definition der aktiven Fläche erfolgt durch Erzeugen der Feldoxid-Bereiche 2 aus Siliziumdioxid mittels eines Nitrid-Prozesses, während die Herstellung der p$^-$-Wanne (4) durch Ionenimplantation nach erfolgter Maskierung mit einer ersten Fotolackschicht durchgeführt wird, die in der Figur nicht dargestellt ist. Weiterhin zeigt diese Figur eine zweite Fotolackschicht 5, die nach dem Entfernen der ersten Fotolackschicht auf die Gate-Oxidschicht 3 aufgebracht wird. Nach der Strukturierung dieser zweiten Fotolackschicht 5 und dem Öffnen des Fotolacks wird mit einer weiteren Ionenimplantation ein n$^+$-Gebiet (Depletion-Gebiet) 6 mit einer Breite von ca. 5 $\mu$m, einer Länge von ca. 20 $\mu$m und einer Tiefe von ca. 1 $\mu$m erzeugt. Anschließend wird diese zweite Fotolackschicht 5 entfernt und eine Silizium-Nitridschicht 7 im Bereich der p$^-$-Wanne 4 abgeschieden, wie sich aus der Anordnung nach Figur 5 ergibt.

Anschließend erfolgt mittels einer Fotolacktechnik (in der Figur 5 nicht dargestellt) die Strukturierung des Depletion-Gebietes 6 zur Herstellung des Grabens 8 gemäß Figur 6, wodurch dieses Gebiet 6 in zwei gleiche Bereiche 6a und 6b zerfällt.

Die Figur 6 zeigt die Anordnung nach der Ätzung des Grabens 8, wobei ersichtlich ist, daß der Graben 8 tiefer als das Depletion-Gebiet 6 reicht. Der Graben 8 weist eine Breite von ca. 5 $\mu$m und eine Tiefe von ca. 1,5 $\mu$m auf, wobei das Depletion-Gebiet 6 ca. 1 $\mu$m tief ist. Außerdem teilt der Graben 8 das vorher hergestellte Depletion-Gebiet 6 symmetrisch in zwei voneinander isolierte Gebiete 6a und 6b, die jeweils die Drainzonen der späteren Speicherzellen darstellen.

Nun wird mittels thermischer Oxidation unter Verwendung der Silizium-Nitridschicht 7 als Maskierung der Graben 8 komplett mit Oxid 9 aufgefüllt, wodurch sich dieser Graben 8 in horizontaler als auch in vertikaler Richtung vergrößert, wie in Figur 7 durch die gestrichelt gezeichnete Umrandung des Grabens 8 dargestellt ist.

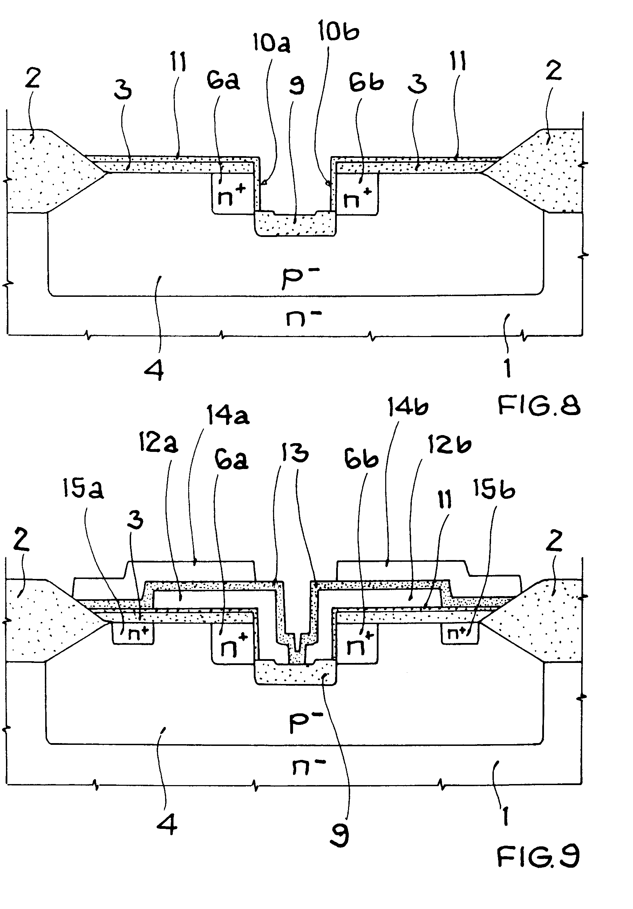

Es folgt ein Naßätzschritt, mit dem ein Teil der an die Drainzonen 6a und 6b angrenzenden Seitenwände 10a und 10b des Grabens 8 - die späteren Tunnelfenster 10a und 10b - freigelegt werden, wie es die Figur 8 zeigt. Weiterhin wird gemäß dieser Figur 8 nach dem Entfernen der Silizium-Nitridschicht 7 die Tunneloxidation zur Erzeugung des Tunneloxids 11 mit einer Dicke von ca. 10 nm durchgeführt.

Im weiteren Prozeßablauf erfolgt die Abscheidung der ersten eine Dicke von ca. 0,5 $\mu$m aufweisende Polysilizium-Schicht, die das Floating-Gate 12a bzw. 12b bildet, wobei die Strukturierung dieser Schicht so erfolgt, daß in dem Trench-Graben 8 zwei Zellen gleichzeitig hergestellt werden. Nun wird in einem Oxidationsprozeß die gesamte Oberfläche im Bereich der p$^-$-Wanne 4 mit einer Polyoxidschicht (SiO$_2$), der Zwischenisolationsschicht 13, mit einer Dicke von ca. 60 nm versehen.

Zur Bildung der Sourcezonen 15a und 15b wird eine weitere Ionenimplantation durchgeführt, der die Abscheidung der zweiten Polysilizium-Schicht folgt. Die Figur 9 zeigt diese Anordnung nach der Strukturierung der zweiten Polysilizium-Schicht zur Bildung der Control-Gates 14a und 14b, die ebenfalls eine Dicke von ca. 0,5 μm aufweisen.

Figur 10 zeigt nun die fertige, aus zwei EEPROM-Speicherzellen bestehende Anordnung nach der Erzeugung der Isolationsschicht 16 als Polyoxidschicht (SiO$_2$) mit einer Dicke von ca. 0,7 μm, der Kontaktlochbereiche 17, der Metall-Leitbahnebene 18 und der abschließenden Oberflächenpassivierung 19. Diese letzten Prozesse werden in bekannter Weise durchgeführt.

In Figur 11 ist das Layout der beiden EEPROM-Speicherzellen nach Figur 10 mit einem gemeinsamen Graben 8, der eine Fläche von ca. 5 μm x 5 μm umfaßt, dargestellt. Hierbei gehört zu jeder Speicherzelle ein zum FLOTOX-Transistor in Serie geschalteter normaler NMOS-Transistor (Select-Transistor) 20a bzw. 20b, der zur Auswahl der Speicherzellen dient. Deutlich ist in dieser Figur die flächensparende Anordnung der seitlichen Tunnelfenster 10a und 10b zu erkennen. Die beiden FLOTOX-Transistoren beanspruchen je eine Fläche von ca. 110 μm$^2$, während die beiden Speicherzellen mit den Select-Transistoren jeweils eine Fläche von ca. 500 μm$^2$ einnehmen, was eine Verkleinerung gegenüber dem Stand der Technik von ca. 50 % bedeutet.

In einem Trench-Graben können nicht nur zwei Speicherzellen angeordnet werden, sondern bei entsprechender Strukturierung der ersten Polysilizium-Ebene können auch drei und mehrere Zellen gleichzeitig mit einem gemeinsamen Trench-Graben hergestellt werden.

**Patentansprüche**

1. Eine nichtflüchtige Speicherzelle bildender FET mit einer Source- und Drainzone (6, 15) sowie einer Floating-Gate-Elektrode (12) als Speicherelektrode, zwischen der und dem Halbleiterkörper (1) ein durchtunnelbares Dielektrikum (11) angeordnet ist, dadurch gekennzeichnet, daß im Halbleiterkörper (1) ein an die der Kanalzone abgewandten Seite der Drainzone (6) angrenzender und mit einer Dielektrikumsschicht (11) belegter Graben (8) vorgesehen ist, und daß sich die Floating-Gate-Elektrode (12) derart in den Graben (8) erstreckt, daß der Tunnelstrom horizontal zur Halbleiteroberfläche zwischen der Drainzone (6) und dem sich in den Graben erstreckenden Bereich der Floating-Gate-Elektrode (12) fließen kann.

2. Eine nichtflüchtige Speicherzelle bildender FET nach Anspruch 1, dadurch gekennzeichnet, daß der Graben (8) quaderförmig ausgebildet ist, und daß durch die Floating-Gate-Elektrode (12) der Speicherzelle eine Seitenwand (10) des Grabens (8) belegt ist.

3. Eine nichtflüchtige Speicherzelle bildender FET nach Anspruch 2, dadurch gekennzeichnet, daß der Graben (8) eine Tiefe von ca. 1,5 μm aufweist.

4. Speicherzellenanordnung mit nichtflüchtigen Speicherzellen nach Anspruch 1, 2 oder 3, dadurch gekennzeichnet, daß mindestens zwei nichtflüchtige Speicherzellen an einem einzigen Graben (8) derart angeordnet sind, daß sich deren Floating-Gate-Elektroden (12) in diesen Graben (8) erstrecken.

5. Anordnung mit mindestens zwei nichtflüchtigen Speicherzellen nach Anspruch 4, dadurch gekennzeichnet, daß die Floating-Gate-Elektroden (12) der Speicherzellen radial um den Graben (8) angeordnet sind.

6. Anordnung mit zwei nichtflüchtigen Speicherzellen nach Anspruch 4, dadurch gekennzeichnet, daß die beiden Floating-Gate-Elektroden (12a, 12b) zwei gegenüberliegende Seitenwände (10a, 10b) des quaderförmigen Grabens (8) belegen.

7. Verfahren zum Herstellen nichtflüchtiger Speicherzellen nach Anspruch 6, gekennzeichnet durch den Ablauf folgender Verfahrensschritte:
a) Erzeugung eines Gate-Oxids (3) auf einem Halbleitersubstrat (1) eines ersten Leitungstyps nach erfolgter Herstellung der aktiven Fläche und einer Wanne (4) eines zweiten Leitungstyps,
b) Herstellung eines Gebietes (6) vom ersten Leitungstyp in der Wanne (4),
c) Herstellung eines Grabens (8) im Bereich des Gebietes (6), so daß zur Bildung der beiden Drainzonen der herzustellenden Speicherzellen dieses Gebiet (6) in zwei Zonen (6a, 6b) zerfällt,
d) Erzeugung eines Tunneloxids (11) im Bereich der Wanne (4) und des Grabens (8),
e) Herstellen der Floating-Gate-Elektroden (12a, 12b) und einer diese Elektroden bedeckende Zwischenisolationsschicht (13),
f) Erzeugung der Sourcezonen (15a, 15b),
g) Herstellen der Control-Gate-Elektroden (14a, 14b) und einer diese Elektroden bedeckende letzte Isolationsschicht (16),
h) Erzeugung der Kontaktlochbereiche (17) in der letzten Isolationsschicht (16), der Metall-Leiterbahnebene (18) und einer Passivierungsschicht (19) in bekannter Weise.

8. Verfahren nach Anspruch 7, dadurch gekennzeichnet, daß im Verfahrensschritt c) der Graben (8) so hergestellt wird, daß er tiefer als das Gebiet (6) reicht.

9. Verfahren nach Anspruch 7 oder 8, dadurch gekennzeichnet, daß im Verfahrensschritt c) der Graben (8) so ausgebildet ist, daß er das Gebiet (6) symmetrisch in zwei gleiche Zonen (6a, 6b) teilt.

10. Verfahren nach einem der Ansprüche 7 bis 9, dadurch gekennzeichnet, daß vor der Durchführung des Verfahrensschrittes c) eine Isolationsschicht (7) im gesamten Bereich der Wanne (4) aufgebracht wird, und daß nach dem Verfahrensschritt c) folgende Verfahrensschritte durchgeführt werden:
    - Auffüllen des Grabens (8) mit einer Oxidschicht (9) unter Verwendung der Isolationsschicht (7) als Maskierung,
    - teilweises Freilegen der Seitenwände (10a, 10b) des Grabens (8) durch Entfernen der Oxidschicht (9),
    - Entfernen der Isolationsschicht (7).

11. Verfahren nach Anspruch 10, dadurch gekennzeichnet, daß die Isolationsschicht (7) aus Silizium-Nitrid besteht.

12. Verfahren nach Anspruch 10 oder 11, dadurch gekennzeichnet, daß die Oxidschicht (9) mittels thermischer Oxidation hergestellt wird.

13. Verfahren nach einem der Ansprüche 10 bis 12, dadurch gekennzeichnet, daß im Verfahrensschritt d) das Tunneloxid (11) im Bereich des Grabens (8) die an die Drainzonen (6a, 6b) angrenzenden, freigelegten Seitenwände (10a, 10b) belegt.

14. Verfahren nach einem der Ansprüche 7 bis 13, dadurch gekennzeichnet, daß im Verfahrensschritt a) die aktive Fläche mittels einer strukturierten Oxidschicht (2) auf dem Halbleitersubstrat (1) durch lokale Oxidation hergestellt wird.

15. Verfahren nach Anspruch 14, dadurch gekennzeichnet, daß das Halbleitersubstrat (1) aus Silizium und die Oxidschicht (2) aus Siliziumdioxid besteht.

16. Verfahren nach einem der Ansprüche 7 bis 15, dadurch gekennzeichnet, daß im Verfahrensschritt a) die Wanne (4) mittels Ionenimplantation und eines Photolackprozesses hergestellt wird.

17. Verfahren nach einem der Ansprüche 7 bis 16, dadurch gekennzeichnet, daß im Verfahrensschritt b) das Gebiet (6) mittels Ionenimplantation und eines Photolackprozesses hergestellt wird.

18. Verfahren nach einem der Ansprüche 7 bis 17, dadurch gekennzeichnet, daß im Verfahrensschritt c) zur Herstellung des Grabens (8) das Gebiet (6) mittels eines Photolackprozesses strukturiert und anschließend geätzt wird.

19. Verfahren nach einem der Ansprüche 7 bis 18, dadurch gekennzeichnet, daß im Verfahrensschritt e) und g) die Gate-Elektroden (12a, 12b, 14a, 14b) aus Polysilizium und letzte Isolationsschicht (16) aus Polysiliziumdioxid bestehen.

20. Verfahren nach einem der Ansprüche 7 bis 19, dadurch gekennzeichnet, daß im Verfahrensschritt e) die Zwischenisolationsschicht (13) aus Polysiliziumdioxid besteht.

21. Verfahren nach einem der Ansprüche 7 bis 19, dadurch gekennzeichnet, daß im Verfahrensschritt e) die Zwischenisolationsschicht (13) aus Silizium-Nitrid besteht.

22. Verfahren nach einem der Ansprüche 7 bis 21, dadurch gekennzeichnet, daß die Sourcezonen (15a, 15b) mittels Ionenimplantation erzeugt werden.

**Claims**

1. An FET forming a non-volatile memory cell having a source and drain zone (6, 15) as well as, as memory electrode, a floating gate electrode (12) between which and the semiconductor body (1) there is arranged a dielectric (11) which can be tunneled through, characterised in that, a trench (8) lined with a dielectric layer (11) is provided in the semiconductor body (1) on the side of the drain zone (6) remote from the channel zone and that the floating gate electrode (12) extends into the trench (8) in such a way that the tunnelling current can flow horizontally relative to the upper surface of the semiconductor between the drain zone (6) and the region of the floating gate electrode (12) extending into the channel.

2. An FET forming a non-volatile memory cell in accordance with claim 1, characterised in that, the trench (8) is formed as a rectangular parallelepiped and that one side wall (10) of the trench (8) is covered by the floating gate electrode (12) of the memory cell.

3. An FET forming a non-volatile memory cell in accordance with claim 2, characterised in that, the trench (8) has a depth of circa 1.5 μm.

4. Memory cell arrangement having non-volatile memory cells in accordance with claim 1, 2 or 3, characterised in that, at least two non-volatile memory cells are arranged in a single trench (8) in such a way that their floating gate electrodes (12) extend into this trench (8).

5. Arrangement of at least two non-volatile memory cells in accordance with claim 4, characterised in that, the floating gate electrodes (12) are arranged radially around the trench (8).

6. Arrangement of two non-volatile memory cells in accordance with claim 4, characterised in that, the two floating gate electrodes (12a, 12b) cover two opposed side walls (10a, 10b) of the rectangular parallelepiped shaped trench (8).

7. Method for the manufacture of non-volatile memory cells in accordance with claim 6, characterised by the following sequence of method steps:
a) production of a gate oxide (3) on a semiconductor substrate (1) of a first conductivity type after the manufacture of the active surface and a trough (4) of a second conductivity type has been effected,
b) production of a region (6) of the first conductivity type in the trough (4),
c) production of a trench (8) in the area of the region (6) so that for the formation of the two drain zones of the memory cells being manufactured, this region (6) is dissociated into two zones (6a, 6b),
d) production of a tunnelling oxide (11) in the area of the trough (4) and the trench (8),
e) manufacture of the floating gate electrodes (12a, 12b) and an intermediate isolating layer (13) covering these electrodes,
f) production of the source zones (15a, 15b),
g) manufacture of the control gate electrodes (14a, 14b) and a final insulating layer (16) covering these electrodes,
h) production of the contact cavity regions (17) in the final insulating layer (16), the metal conductive track planes (18) and a passivating layer (19) in the known manner.

8. Method in accordance with claim 7, characterised in that, in the method step c), the trench (8) is made such that it extends more deeply than the region (6).

9. Method in accordance with claim 7 or 8, characterised in that, in the method step c), the trench (8) is formed such that it symmetrically divides the region (6) into similar zones (6a, 6b).

10. Method in accordance with any of the claims 7 to 9, characterised in that, before the carrying out of the method step c), an isolating layer (7) is applied in the whole area of the trough (4) and that after the method step c), the following method steps are carried out:
    - filling of the trench (8) with an oxide layer (9) by use of the isolating layer (7) as masking,
    - partial exposure of the side walls (10a, 10b) of the trench (8) by removal of the oxide layer (9),
    - removal of the isolating layer (7).

11. Method in accordance with claim 10, characterised in that, the insulating layer (7) consists of silicon nitride.

12. Method in accordance with claim 10 or 11, characterised in that, the oxide layer (9) is produced by means of thermal oxidation.

13. Method in accordance with any of the claims 10 to 12, characterised in that, in the method step d), the tunnelling oxide (11) in the area of the trench (8) covers the exposed side walls (10a, 10b) bordering onto the drain zones (6a, 6b).

14. Method in accordance with any of the claims 7 to 13, characterised in that, in the method step a), the active surface is produced by means of a structured oxide layer (2) on the semiconductor substrate (1) by local oxidation.

15. Method in accordance with claim 14, characterised in that, the semiconductor substrate (1) consists of silicon and the oxide layer (2) of silicon dioxide.

16. Method in accordance with any of the claims 7 to 15, characterised in that, in the method step a), the trench (4) is produced by means of ion implantation and a photo resist process.

17. Method in accordance with any of the claims 7 to 16, characterised in that, in the method step b), the region (6) is produced by means of ion implantation and a photo resist process.

18. Method in accordance with any of the claims 7 to 17, characterised in that, in the method step b) for the manufacture of the trench (8), the region (6) is structured by means of a photo resist process and thereafter is etched.

19. Method in accordance with any of the claims 7 to 18, characterised in that, in the method step e) and g), the gate electrodes (12a, 12b, 14a, 14b) consist of polysilicon and the final insulating layer (16) of polysilicon dioxide.

20. Method in accordance with any of the claims 7 to 19, characterised in that, in the method step e), the intermediate isolating layer (13) consists of polysilicon dioxide.

21. Method in accordance with any of the claims 7 to 19, characterised in that, in the method step e), the intermediate isolating layer (13) consists of silicon nitride.

22. Method in accordance with any of the claims 7 to 21, characterised in that, the source zones (15a, 15b) are produced by means of ion implantation.

**Revendications**

1. Cellule mémoire non volatile formée par un transistor à effet de champ, comprenant une zone de source et une zone de drain (6, 15) ainsi qu'une électrode de grille flottante (12) comme électrode de mémorisation, avec disposition, entre cette électrode et le corps semi-conducteur (1), d'un diélectrique (11) traversable par des électrons par effet tunnel, caractérisée en ce qu'un caisson (8) est prévu dans le corps semi-conducteur (1), caisson qui est limitrophe au côté de la zone de drain (6) éloigné de la zone de canal et est recouvert d'une couche de diélectrique (11), et que l'électrode de grille flottante (12) s'étend dans le caisson (8) de manière que le courant de tunnel puisse circuler horizontalement ou parallèlement à la surface de semi-conducteur entre la zone de drain (6) et la partie s'étendant dans le caisson de l'électrode de grille flottante (12).

2. Cellule mémoire non volatile formée par un transistor à effet de champ selon la revendication 1, caractérisée en ce que le caisson (8) possède une forme parallélépipédique et que l'électrode de grille flottante (12) de la cellule mémoire occupe une paroi latérale (10) du caisson (8).

3. Cellule mémoire non volatile formée par un transistor à effet de champ selon la revendication 2, caractérisée en ce que le caisson (8) possède une profondeur d'environ 1,5 $\mu$m.

4. Dispositif de cellules mémoires comportant des cellules mémoires non volatiles selon la revendication 1, 2 ou 3, caractérisé en ce qu'au moins deux cellules mémoires non volatiles sont disposées sur un caisson (8) unique de manière que leurs électrodes de grille flottante (12) s'étendent dans ce caisson (8).

5. Dispositif comportant au moins deux cellules mémoires non volatiles selon la revendication 4, caractérisé en ce que les électrodes de grille flottante (12) des cellules mémoires sont disposées radialement autour du caisson (8).

6. Dispositif comportant deux cellules mémoires non volatiles selon la revendication 4, caractérisé en ce que les deux électrodes de grille flottante (12a, 12b) occupent deux parois latérales (10a, 10b) opposées du caisson parallélépipédique (8).

7. Procédé pour fabriquer des cellules mémoires non volatiles selon la revendication 6, caractérisé par la séquence des étapes de procédé suivantes:

a) production d'un oxyde de grille (3) sur un substrat semi-conducteur (1) d'un premier type de conductivité après la fabrication de la surface active et d'une cuvette (4) d'un second type de conductivité,

b) fabrication d'une région (6) du premier type de conductivité dans la cuvette (4),

c) fabrication d'un caisson (8) dans le secteur de la région (6), de manière que, pour la formation des deux zones de drain des cellules mémoires à fabriquer, cette région (6) se partage en deux zones (6a, 6b),

d) production d'un oxyde de tunnel (11) dans le secteur de la cuvette (4) et du caisson (8),

e) fabrication des électrodes de grille flottante (12a, 12b) et d'une couche d'isolement intermédiaire (13) recouvrant ces électrodes,

f) production des zones de source (15a, 15b),

g) fabrication des électrodes de grille de commande (14a, 14b) et d'une dernière couche d'isolement (16) recouvrant ces électrodes et

h) production, de façon connue, des secteurs à trous de contact (17) dans la dernière couche d'isolement (16), du plan des pistes conductives métalliques (18) et d'une couche de passivation (19).

8. Procédé selon la revendication 7, caractérisé en ce que le caisson (8) est réalisé, dans l'étape c) du procédé, de manière qu'il s'étende jusqu'à une plus grande profondeur que la région (6).

9. Procédé selon la revendication 7 ou 8, caractérisé en ce que le caisson (8) est réalisé, dans l'étape c) du procédé, de manière qu'il partage la région (6) symétriquement en deux zones égales (6a, 6b).

10. Procédé selon une des revendications 7 à 9, caractérisé en ce que, avant l'exécution de l'étape c) du procédé, on applique une couche d'isolement (7) dans tout le secteur de la cuvette (4) et que, après l'étape c) du procédé, on exécute les étapes de procédé suivantes:
    - remplissage du caisson (8) avec un couche d'oxyde (9) en utilisant la couche d'isolement (7) comme masque,
    - dégagement partiel des parois latérales (10a, 10b) du caisson (8) par enlèvement de la couche d'oxyde (9) et
    - enlèvement de la couche d'isolement (7).

11. Procédé selon la revendication 10, caractérisé en ce que la couche d'isolement (7) est en nitrure de silicium.

12. Procédé selon la revendication 10 ou 11, caractérisé en ce que l'on produit la couche d'oxyde (9) par oxydation thermique.

13. Procédé selon une des revendications 10 à 12, caractérisé en ce que, dans l'étape d) du procédé, l'oxyde de tunnel (11) à l'intérieur du caisson (8) recouvre les parois latérales (10a, 10b) limitrophes aux zones de drain (6a, 6b) et dégagées.

14. Procédé selon une des revendications 7 à 13, caractérisé en ce que, dans l'étape a) du procédé, on réalise la surface active au moyen d'une couche d'oxyde (2) structurée sur le substrat semi-conducteur (1) par oxydation locale.

15. Procédé selon la revendication 14, caractérisé en ce que le substrat semi-conducteur (1) est en silicium et la couche d'oxyde (2) est en dioxyde de silicium.

16. Procédé selon une des revendications 7 à 15, caractérisé en ce que, dans l'étape a) du procédé, la cuvette (4) est réalisée par implantation ionique et par un processus de photogravure utilisant une couche de résine photosensible.

17. Procédé selon une des revendications 7 à 16, caractérisé en ce que, dans l'étape b) du procédé, on réalise la région (6) par implantation ionique et par un processus de photogravure utilisant une couche de résine photosensible.

18. Procédé selon une des revendications 7 à 17, caractérisé en ce que, dans l'étape c) du procédé, pour former le caisson (8), on structure la région (6) au moyen d'un processus à résine photosensible et on la soumet ensuite à une gravure.

19. Procédé selon une des revendications 7 à 18, caractérisé en ce que, dans les étapes e) et g) du procédé, les électrodes de grille (12a, 12b, 14a, 14b) sont en polysilicium et la dernière couche d'isolement (16) est en dioxyde de polysilicium.

20. Procédé selon une des revendications 7 à 19, caractérisé en ce que, dans l'étape e) du procédé, la couche d'isolement intermédiaire (13) est en dioxyde de polysilicium.

21. Procédé selon une des revendicarions 7 à 19, caractérisé en ce que, dans l'étape e) du procédé, la couche d'isolement intermédiaire (13) est en nitrure de silicium.

22. Procédé selon une des revendications 7 à 21, caractérisé en ce que les zones de source (15a, 15b) sont formées par implantation ionique.

FIG.1

FIG.2

FIG.3

FIG.4

FIG.5

FIG.6

FIG.7

EP 0 341 647 B1

FIG.8

FIG.9

FIG.10

EE PROM-ZELLE 1                     EE PROM-ZELLE 2

FIG.11

EEPROM-ZELLE 1     EEPROM-ZELLE 2